# EUROPÄISCHE PATENTSCHRIFT

(11) **EP 0 953 205 B1**
(45) Veröffentlichungstag und Bekanntmachung des Hinweises auf die Patenterteilung: **12.03.2003**
(21) Anmeldenummer: 97910405.6
(22) Anmeldetag: 01.10.1997
(51) Int. Cl.: H01L 21/00

(54) **VORRICHTUNG ZUM BEHANDELN VON SUBSTRATEN**
SUBSTRATE TREATMENT DEVICE
DISPOSITIF DE TRAITEMENT DE SUBSTRATS

(30) Priorität: 24.10.1996 DE 19644253
(43) Veröffentlichungstag der Anmeldung: 03.11.1999
(73) Patentinhaber: STEAG MicroTech GmbH, 72124 Pliezhausen (DE)
(72) Erfinder: OSHINOWO, John, D-78073 Bad Dürrheim (DE)
(74) Vertreter: Wagner, Karl H., Dipl.-Ing.
(86) Internationale Anmeldenummer: EP9705407
(87) Internationale Veröffentlichungsnummer: WO98018155

(56) Entgegenhaltungen:
- US-A- 5 370 142
- US-A- 5 474 616
- US-A- 5 482 068

## Beschreibung

Die Erfindung betrifft eine Vorrichtung zum Behandeln von Substraten in einem eine Behandlungsflüssigkeit enthaltenden Behälter, in den die Behandlungsflüssigkeit von unten durch einen Behälterboden einströmt.

Aus den auf die Anmelderin der vorliegenden Anmeldung zurückgehenden DE 44 13 077 A1, DE 195 46 990 A1 sind Vorrichtungen der genannten Art bekannt und darüber hinaus auch in den nicht-vorveröffentlichten deutschen Patentanmeldungen DE 195 37 879.2, DE 196 16 402.8, DE 196 15 969.5 oder DE 196 37 875.3 derselben Anmelderin beschrieben. Diese Vorrichtungen haben sich in der Praxis sehr bewährt. Dennoch benötigen diese Vorrichtungen ein relativ hohes Volumen an Behandlungsfluid, das teuer und umweltbelastend ist und sehr aufwendig wieder aufbereitet werden muß. Darüber hinaus besteht die Forderung nach einem möglichst gleichmäßigen Strömungsverhalten des Behandlungsfluids im Behandlungsbehälter, um die zu behandelnden Substrate insbesondere beim Spülvorgang gleichmäßig und über die gesamten Substratflächen hinweg einheitlich behandeln zu können.

Aus den Druckschriften JP 3-266 431 A2 und JP 5-136 116 A2 sind Vorrichtungen der eingangs genannten Art bekannt, bei denen die Form des Behälterbodens kreisbogenförmig ist und der Form von kreisförmigen Scheiben entspricht. Die aus der JP 7 249 604 A2 bekannte Vorrichtung weist einen an die Form einer Kassette angepaßten Behälterboden auf, wobei die Kassetten bei der Fluidbehandlung in der Kassette angeordnet sind. Das Fluid wird bei dieser bekannten Vorrichtung nicht von unten durch den Behälterboden eingeleitet. Der Behälterboden enthält lediglich Auslaßöffnungen, durch die das im Fluidbehälter befindliche Fluid abgelassen wird. Aus der US-Patentschrift 5 071 488 und der JP 6-252 120 A2 sind Vorrichtungen mit Fluideinlaß von unten bekannt, bei denen die Wafer während der Behandlung in einer Kassette angeordnet sind, und das Fluid über einen Auslauf im oberen Bereich des Fluidbehälters abfließt. Aus der JP 4-267 981 A2 ist eine Vorrichtung der eingangs genannten Art bekannt, bei der ein Entlüftungsrohr vorgsehen ist, das mit einem Zuleitungsbereich unterhalb des eigentlichen Fluidbehälters in Verbindung steht und der Ableitung von Luftblasen dient, die im zugeführten heißen, reinen Wasser auftreten können.

Aus der US 5 014 727, der JP 7-106 295 A2 und der JP 5-259 143 A2 sind Vorrichtungen der eingangs genannten Art bekannt, bei denen das von unten einzuleitende Fluid unterhalb des Behälterbodens auf unterschiedliche Verteilungskanäle oder -Rohre verteilt wird. Die JP 6-196 466 A2 zeigt einen Reinigungstank, bei der die Reinigungsflüssigkeit von unten durch Schlitze, die in Richtung der Waferkanten angeordnet sind, in den Reinigungstank eingeleitet wird. Bei der aus der JP 5-232 978 A2 bekannten Substrat-Behandlungsvorrichtung besteht der Behälterboden aus mehreren übereinander angeordneten Platten, in denen Öffnungen jeweils so ausgebildet sind, daß das von unten eingeleitete Behandlungsfluid auf eine Vielzahl von Auslaßöffnungen verteilt wird.

Aus der US 5 474 616 ist eine Wafer-Reinigungsvorrichtung bekannt, bei der die aus mit Löchern versehenen Röhren austretende Flüssigkeit gesammelt und über einen schmalen Schlitz in Richtung auf die Wafer geleitet wird. Die Röhren und diese Anordnung zur Richtung des Fluidstroms auf die Wafer sind im Fluidbecken selbst angeordnet.

Aus der US 5 370 142 ist eine Wafer-Waschvorrichtung bekannt, bei der die Wafer in einem von unten nach oben gerichteten Strom innerhalb des Behandlungstanks behandelt werden. Die Wafer werden dabei von Waferhalterungen gehalten, die sich im Fluid-Strömungsbereich, d. h. zwischen den Fluideintrittsöffnungen und den Wafern befinden. Um auch im Halterungsbereich die Möglichkeit einer Waferbehandlung zu haben, befinden sich in den Waferhaltern Öffnungen, durch die das Fluid über eine eigene Leitung hindurch gepumpt wird, um auf diese Weise das Fluid auch in die Aufnahmeschlitze der Halterungen zu führen.

Aus der US 5 482 068 ist eine Vorrichtung zum Behandeln von Substraten mit einem eine Behandlungsflüssigkeit enthaltenden Behälter bekannt. Die Behandlungsflüssigkeit strömt von unten durch einen den unteren Abschluss des die Behandlungsflüssigkeit aufnehmenden Behälters bildenden Behälterboden ein. Der Behälterboden weist integral und einstückig ausgebildete Einlassöffnungen für die Behandlungsflüssigkeit sowie integral und einstückig ausgebildete Flüssigkeitskanäle zur Versorgung der Einlassöffnungen mit Behandlungsflüssigkeit auf.

Der Erfindung liegt die Aufgabe zugrunde, eine Vorrichtung zu schaffen, die bei geringem konstruktivem und fertigungstechnischem Aufwand mit einer möglichst geringen Menge an Behandlungsflüssigkeit auskommt und insbesondere eine optimale, über die gesamten Substratflächen hinweg gleichmäßige Behandlung der Substrate erlaubt.

Die gestellte Aufgabe wird durch die Merkmale des Anspruches 1 gelöst.

Der Behälterboden weist integral innerhalb des Behälterbodens ausgebildete Einlaßöffnungen und Flüssigkeitskanäle für die Behandlungsflüssigkeit auf. Der Behälterboden ist dabei integral vorzugsweise derart ausgebildet und ausgeformt, daß die Einlaßöffnungen auch in Form von Einlaßdüsen mit optimalen Gegebenheiten ausgebildet sind. Der Bodenbehälter wird als fertiges Bauelement mit bereits darin integral ausgebildeten Einlaßöffnungen oder -düsen gefertigt, so daß keine Montage erforderlich ist und auch die Einlaßdüsen nicht - wie dies beispielsweise im Falle der nicht vorveröffentlichten DE 196 16 402 derselben Anmelderin als Ausführungsbeispiel beschrieben ist - montiert und in den Behälterboden eingesetzt zu werden brauchen. Dadurch werden erhebliche Montagekosten und Justierarbeiten eingespart, und es sind auch keine Bearbeitungsschritte zur Ausbildung von Gewinden oder dergleichen für die Düsen erforderlich. Ein besonders großer Vorteil besteht zusätzlich darin, daß die Einlaßöffnungen und auch die Zuführungen zu diesen Öffnungen mit wesentlich kleinerem Volumen ausgestattet werden können, so daß Öffnungen und Hohlräume klein gehalten sind, und damit unnötige Flüssigkeitsvolumen und insbesondere auch die Ansammlung und Entstehung von Luftblasen zuverlässig vermieden ist. Darüber hinaus können die Einlaßöffnungen und Düsen in ihrer Form und Ausbildung jeweils der entsprechenden Lage im Behälterboden im Hinblick auf eine besonders gleichmäßige Strömungsverteilung im Behälter optimal ausgeführt und angeordnet werden. Die Düsenform und/oder -anordnung der Düsen im Behälterboden ist dabei ohne nachträgliches Justieren möglich.

Gemäß der Erfindung weist der Behälterboden integral ausgebildete Flüssigkeitskanäle zur Versorgung der Einlaßöffnungen mit der Behandlungsflüssigkeit auf. Gemäß diesem Merkmal sind auch die die Einlaßöffnungen mit Flüssigkeit versorgenden Flüssigkeitskanäle innerhalb des Behälterbodens integral ausgebildet. Sie müssen daher nicht verlegt oder montiert werden. Insbesondere ist es dadurch möglich, die Flüssigkeitskanäle, deren Anordnung und Durchmesser optimal an die jeweiligen Einlaßöffnungen anzupassen, so daß keine toten Hohlräume oder Abreißkanten entstehen, die nicht gut durchströmte Bereiche und Blasenbildung verursachen.

Der Behälterboden einschließlich der darin ausgebildete Einlaßöffnungen, seien es Einlaßdüsen oder Einlaßlöcher und der ebenfalls darin ausgebildeten Flüssigkeitskanälen ist vorzugsweise mit einem Spritzgußverfahren herstellbar. Eine weitere vorteilhafte Ausgestaltung besteht auch darin, die Behälterboden mit integralen Einlaßöffnungen und Kanälen unter Verwendung der Laserlithographie-Technik zu fertigen.

Gemäß einer weiteren vorteilhaften Ausgestaltung der Erfindung weist der Behälterboden wenigstens einen Anschluß-Kanal zur Einleitung der Behandlungsflüssigkeit in den Behälterboden auf. Der Behälterboden ist dabei vorzugsweise im Anschlußbereich integral mit einem Innengewinde versehen, an dem die Leitung für die Behandlungsflüssigkeit angeschlossen bzw. eingeschraubt werden kann. Auch dieses Merkmal trägt zu einer einheitlichen, einstückigen Behälterboden-Anordnung bei und ist auf einfache Weise herstellbar.

Gemäß einer weiteren sehr vorteilhaften Ausgestaltung der Erfindung ist der Anschlußkanal am Eingang des Behälterbodens in mehrere Abschnitte, vorzugsweise in vier Abschnitte, aufgeteilt. Vom Anschlußkanal zweigen gemäß einer weiteren Ausführungsform der Erfindung mehrere Kanalarme ab, die vorzugsweise den einzelnen, aufgeteilten Abschnitten zugeordnet sind. Dadurch ist es möglich, im Inneren des Bodenbehälters ein Flüssigkeit-Verteilungssystem auf einfache Weise und optimal an die Gegebenheiten angepaßt fertigen zu können. Vorteilhaft ist es dabei, wenn die Kanalarme zu den Kanalenden hin abnehmende Querschnittsflächen aufweisen. Dadurch wird, wie dies bereits zuvor beschrieben wird, eine gleichmäßige Druckverteilung über die Kanalarme hinweg erreicht.

Gemäß einer weiteren ausführungsform, eine optimale über die gesamte Substratfläche hinweg und an allen Substratstellen gleichmäßige Behandlung zu erreichen, ist es sehr vorteilhaft, wenn die in der Behandlungsflüssigkeit enthaltenen oder sich bei der Einleitung der Behandlungsflüssigkeit bildenden Bläschen, die sogenannten "Bubbles", in dafür vorgesehenen Entgasungskanälen oder-rinnen abgeführt werden. Die Bläschen beeinflussen die Behandlung der Substrate nachteilig, beispielsweise dadurch, daß durch sie eine ungleichmäßige Beaufschlagung der Substrate mit der Behandlungsflüssigkeit, beispielsweise einer Spülflüssigkeit erfolgt, oder diese Bläschen zeitweilig an den Substratflächen anhaften, so daß dort die Behandlung der Substrate mit der Behandlungsflüssigkeit unterschiedlich zu anderen Bereichen des Substrats ist.

Vorzugsweise befinden sich die Entgasungsrinnen oder -kanäle an den Seitenwänden des Behälters, und insbesondere an den quer zu den Substratflächen verlaufenden Behälterwänden. Die Bläschen sammeln sich in diesen Rinnen, so daß die eigentliche Behandlungsflüssigkeit, welches mit den zu behandelnden Substraten in Kontakt kommt, weitgehend bläschenfrei ist.

Im Falle, daß der Behälterboden eine runde bzw. im Querschnitt kreisbogenförmige Form aufweist, befinden sich die Entgasungsrinnen im oberen Bereich des seitliche ansteigenden Behälterbodens.

Besonders vorteilhaft ist es, wenn die Form des Behälterbodens der Form der zu behandelnden Substrate entspricht. Auf diese Weise werden unnötige Volumina im Behälter vermieden, so daß dadurch das Flüssigkeitsvolumen im Behälter verringert und die Strömungseigenschaften im Behälter insbesondere um die Subsrate herum mit gleichmäßigerer Strömungsverteilung und damit gleichmäßigerem Behandeln der Substrate über die gesamten Substratbereiche hinweg verbessert wird. Dadurch ist es nicht nur möglich, die benötigte Menge an teuerer Behandlungsflüssigkeit zu reduzieren, sondern auch die Behandlungsabläufe bei gleichem Behandlungsergebnis, etwa während des Spülvorgangs, zu verkürzen, da weniger Behandlungsflüssigkeit aus dem Behälter abgelassen bzw. in dem Behälter eingeführt werden muß. Durch die Anpassung der Bodenform an die Substratform läßt sich darüber hinaus auch das Strömungsverhalten im Behälter und damit das Behandlungsergebnis, etwa durch gleichmäßige Spülung der Substrate, verbessern.

Insbesondere bei scheibenförmigen Substraten, etwa für die Behandlung von scheibenförmigen Wafern, CD's oder CD'ROMS, aber auch von scheibenförmigen Masken oder LED-Anzeigeeinrichtungen ist eine im Querschnitt runde oder kreisbodenförmige Form des Bodenbehälters vorteilhaft. Die Form des runden Bodenbehälters ist dabei vorzugsweise konzentrisch zu den scheibenförmigen Substraten. Auf diese Weise werden tote und für die Behandlung der Substrate nicht erforderliche Behälterbereiche und Flüssigkeit-Volumina vermieden. Die Einlaßöffnungen können auf dem runden Behälterboden zur Schaffung gleichmäßiger Strömungsverhältnisse im Fluidbehälter optimaler angeordnet werden, als dies bei herkömmlichen Flüssigkeitsbehältern mit flachem oder etwas schrägem Beckenboden der Fall ist.

Vorzugsweise sind im Bereich eines Substrathalters die Einströmschlitze und/oder weitere Eintrittsöffnungen, etwa zusätzliche Düsen, so ausgebildet und ausgerichtet, daß das Behandlungsflüssigkeit in den Behälterbereich um und über den Substrathalter gelenkt wird. Dies ist auch mit entsprechend ausgebildeten Führungselementen möglich. Auf diese Weise werden auch tote Strömungswinkel, die auf Grund des Substrathalters auftreten können, vermieden. Um insofern Wiederholungen zu vermeiden, wird insbesondere auch auf die DE 196 44 253 A derselben Anmelderin mit gleichem Anmeldetag verwiesen.

Die Vorrichtung für die Behandlung von Substraten ist für alle Arten von Substraten verwendbar. Der Begriff Substrate umfaßt nicht nur Wafer, CD's, CD-ROM's, Masken oder LED-Anzeigetafeln, sondern alle Objekte oder Gegenstände, die einer Oberflächenbehandlung, einem Spül- oder Trocknungsvorgang zu unterziehen sind.

Weitere Merkmale, Ausgestaltungen und Vorteile der vorliegenden Erfindung werden nachfolgend anhand von der folgenden Beschreibung mit Hinweis auf die Figuren erläutert. Es zeigen:
- Fig. 1: die schematische Querschnittsdarstellung einer Vorrichtung mit an die Substratform angepaßter Bodenform,
- Fig.2: einen schematischen Querschnitt durch eine Vorrichtung mit einem Flüssigkeitsverteilersystem unterhalb des Behälterbodens,
- Fig.3: den mit Einströmschlitz ausgebildeten Behälterboden in Aufsicht,
- Fig.4: eine Vorrichtung mit Verteilungskanäle unterhalb des Behälterbodens,
- Fig.5a: und 5b eine schematische Darstellung einer Vorrichtung mit einem Einström-Schlitzboden in Aufsicht und im Querschnitt,
- Fig.6a: und 6b eine weitere Vorrichtung mit einem Einström-Schlitzboden in Aufsicht und im Querschnitt,
- Fig.7a: und 7b eine weitere Vorrichtung mit einem Einström-Schlitzbodens in Aufsicht und im Querschnitt,
- Fig. 8: eine schematische Teildarstellung eines integral ausgebildeten Behälterbodens mit integralen Einlaßöffnungen und Einlaßkanälen im Querschnitt,
- Fig. 9: eine schematische, teilweise Querschnitts- und Aufsichtsdarstellung des in Fig. 8 dargestellten integralen Behälterbodens und
- Fig.10: einen Querschnitt durch den Behälterboden in einer zur Darstellung gemäß Fig. 9 um 90° gedrehten Querschnittsebene.

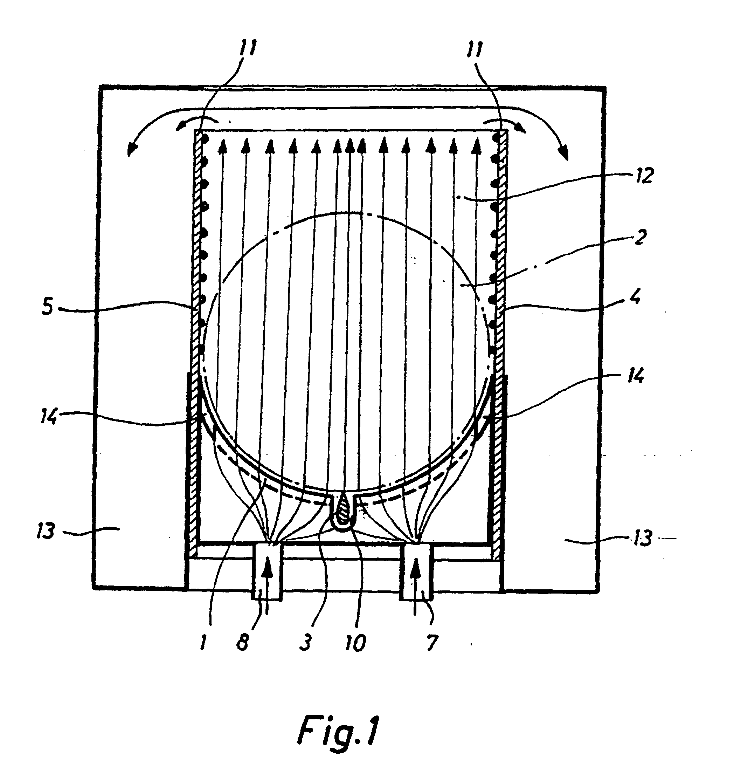

Bei der in Fig. 1 dargestellten Vorrichtung weist der Behälterboden 1 eine den Substraten 2 angepaßte Form, nämlich eine runde Kreisform auf. Die Substrate 2 liegen mit ihren Kanten auf einem Substrathalter 3 auf, der im dargestellten Ausführungsbeispiel die Form eines messerartigen Stegs aufweist und zum Ein- und Ausfahren der Substrate auf- und abbwegbar ist. An den Seitenwänden 4 und 5 werden die Substrate zwischen in Längsreihen angeordneten Noppen geführt, die von den Behälterwänden 4, 5 nach innen abstehen.

Die Behandlungsflüssigkeit wird über Zuleitungen 7, 8 in den Behälterboden 1 eingeleitet und dort auf entsprechende Einlaßöffnungen in der Behälterboden-Austrittsfläche und gegebenenfalls auch in einen Schacht 10 für den Substrathalter 3 verteilt. Die von unten eingeleitete Behandlungsflüssigkeit strömt danach an den Substraten 2 entlang, behandelt oder spült diese und strömt über Überlaufkanten 11 am oberen Rand des Flüssigkeitsbehälters 12 aus diesem aus in einen Überlaufbehälter 13. Auf Grund der an die Waferform angepaßten Bodenform des Flüssigkeitsbehälters 12 besteht kein totes Volumen in ihm und auch die Flüssigkeitsverteilung auf die Substrate 2 wird wesentlich verbessert, so daß gleichmäßige, optimale Strömungsverhältnisse im Flüssigkeitsbehälter 12 auftreten, und alle Bereiche der Substrate 2 gleichmäßig mit der Behandlungsflüssigkeit beaufschlagt werden.

In den oberen Bereichen des runden bzw. im Querschnitt kreisförmigen Behälterbodens 1 befinden sich am oder in der Nähe der Behälterwände 4, 5 Entgasungsrinnen 14, in denen die in der eingeleiteten Behandlungsflüssigkeit auftretenden Bläschen, die auch bei Einströmen in den Flüssigkeitsbehälter 12 entstehen können, gesammelt und vom Inneren des Flüssigkeitsbehälters 12 zurückgehalten werden.

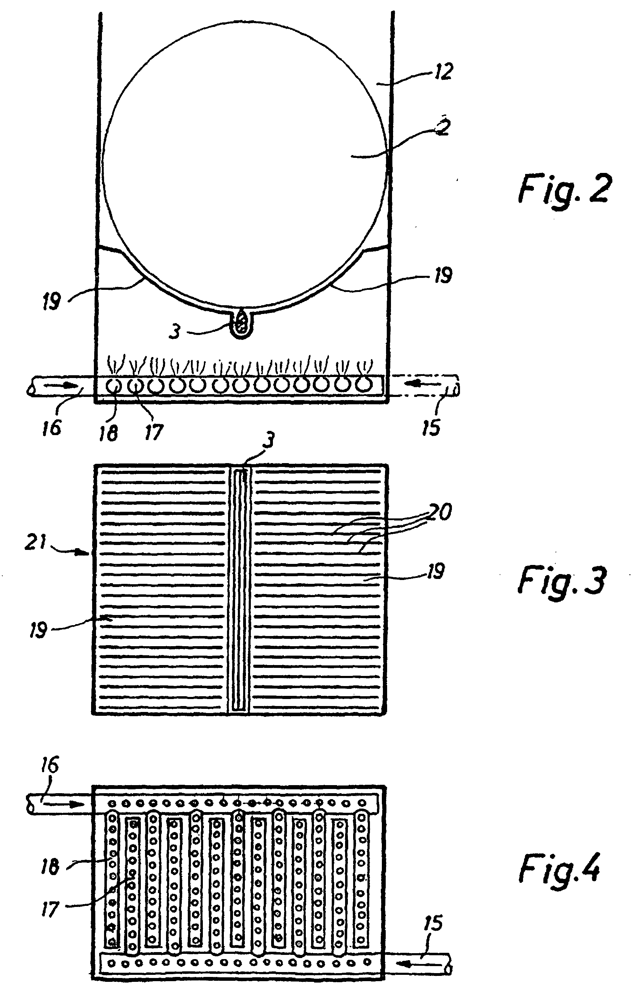

Die Fig. 2, 3 und 4 zeigen eine Vorrichtung, bei der das Flüssigkeit-Zuleitungssystem unterhalb des Behälterbodens 1 zwei auf verschiedene Seiten des Flüssigkeitsbehälters verlaufende und jeweils getrennt mit Behandlungsflüssigkeit gespeiste Einströmrohre 15, 16 aufweist, von denen in einer Ebene jeweils Verteilungskanäle 17, 18 kammartig quer abstehen. Die Verteilungskanäle 17, 18 der Einströmrohre 15, 16 liegen jeweils abwechselnd zwischeneinander. Dadurch ergibt sich eine gleichmäßige Flüssigkeits- bzw. Strömungs- oder Druckverteilung über die gesamte Diffusoranordnung hinweg. Am Ende der Verteilungskanäle 17, 18 ist der Flüssigkeit-Druck am geringsten. Parallel zu ihnen befinden sich jedoch die von dem anderen Einströmrohr 16 bzw. 15 abzweigende Verteilungskanäle mit an dieser Stelle relativ großem Flüssigkeit-druck, da diese Stelle noch nicht so weit vom Einströmrohr 15, 16 beabstandet sind. Auf diese Weise findet ein Ausgleich der Druckverhältnisse über die Fläche hinweg statt, so daß sich eine gleichmäßige Strömungsmittelverteilung über die gesamte Diffuscrfläche hinweg ergibt. Ein Querschnitt durch die in Fig. 4 dargestellte schematische Aufsichtsdarstellung des Diffusorsystems ist in Fig. 2 dargestellt, die das Diffusorsystem in Zuordnung zu dem Flüssigkeitsbehälter 12 zeigt.

Zwischen dem Diffusorsystem gemäß Fig. 4 und einer Behälterbodenaustrittsfläche 19 befinden sich Einströmschlitze 20, die einen Schlitzboden 21 bilden und das Diffusorsystem gemäß Fig. 4 mit der Behälterbodenaustrittsfläche 19 verbinden. Die Schlitze 20 verlaufen dabei in Richtung der Kanten der zu behandelnden Substrate 2, wobei der Substrathalter 3, der die Form eines messerartigen Stegs besitzt, sich quer zu den Einströmschlitzen erstreckt.

Die Schlitze 20 sind bezüglich der Substrate 2 zu in ihrer Lage so gewählt, daß die Behandlungsflüssigkeit aus ihnen zwischen die Substrate 2 strömt.

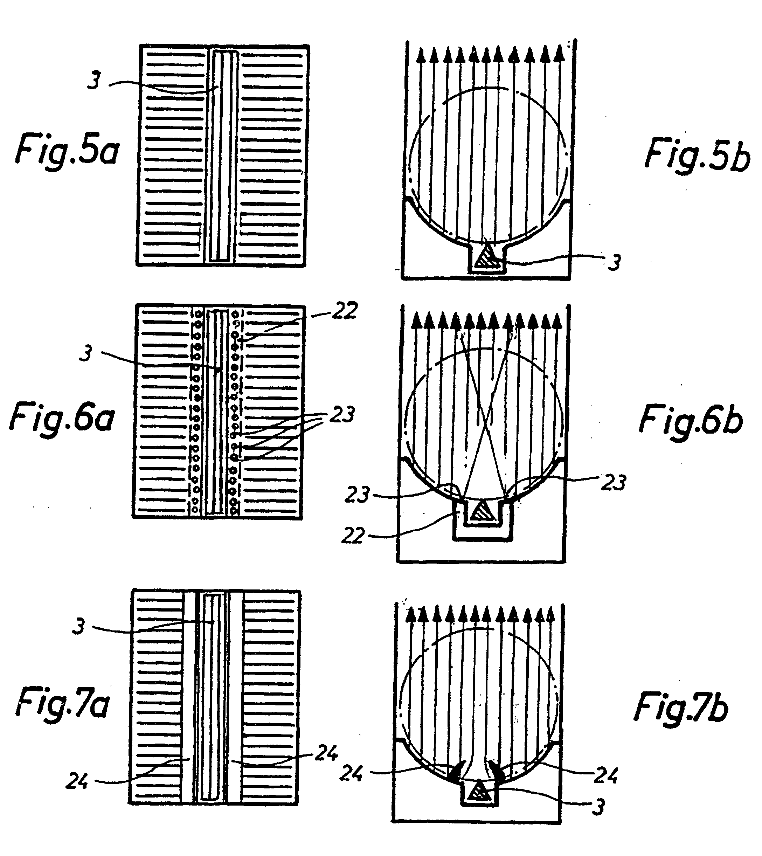

Fig. 5a und 5b zeigt eine Schlitzanordnung bzw. eine Strömungsverteilung, die jeglichen toten Winkeln über dem Substrathalter 3 keine Rechnung trägt. Dagegen zeigt die in Fig. 6a und 6b dargestellte Vorrichtung einen Bereich 22 um den Substrathalter 3 herum, der sich vom Einströmschlitz-Bereich dadurch unterscheidet, daß Düsen 23 vorgesehen sind, die so ausgerichtet oder angeordnet sind, daß die Behandlungsflüssigkeit auch in einen Bereich über dem Substrathalter 3 strömt. Die Düsen 23, sind auf beiden Seiten des Substrathalters 3 jeweils in einer Reihe angeordnet, wie dies Fig. 6a schematisch zeigt.

Bei der in Fig. 7a und 7b dargestellten Vorrichtung wird eine gleichmäßige Strömungsverteilung auch über dem Substrathalter 3 durch Flüssigkeit-Führungs- oder Leitelemente 24 bewirkt, die jeweils auf beiden Seiten des Substrathalters 3 parallel zu diesem verlaufen und so geformt sind, daß auch oberhalb des Substrathalters 3 eine gleichmäßige Strömungsverteilung ohne Totwinkel erreicht wird.

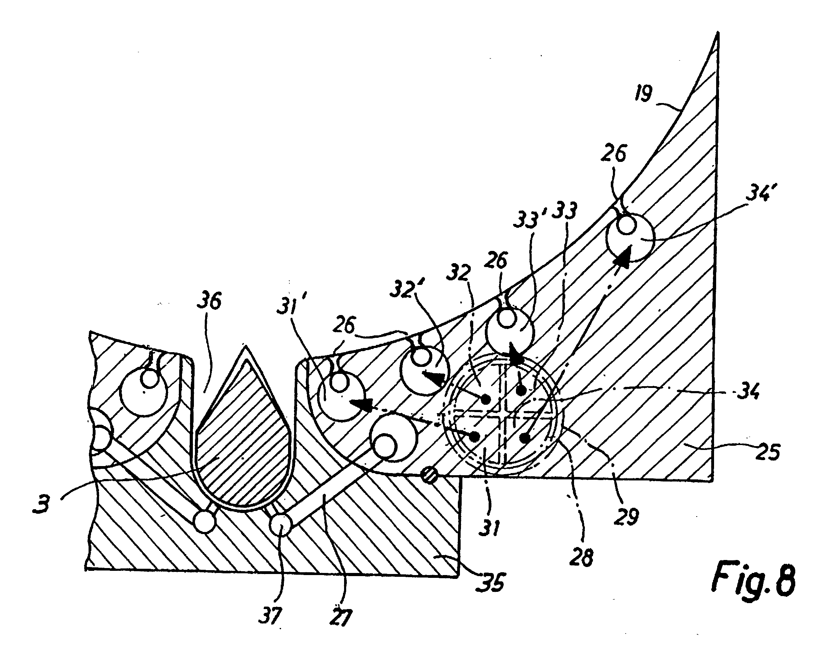

Die Fig. 8, 9 und 10 zeigen eine Ausführungsform eines Behälterbodens 25, in dem sowohl die Einlaßöffnungen 26 als auch die die Einlaßöffnungen 26 mit Flüssigkeit versorgenden Flüssigkeitskanäle 27, 31'-34' integral und einstückig ausgebildet sind.

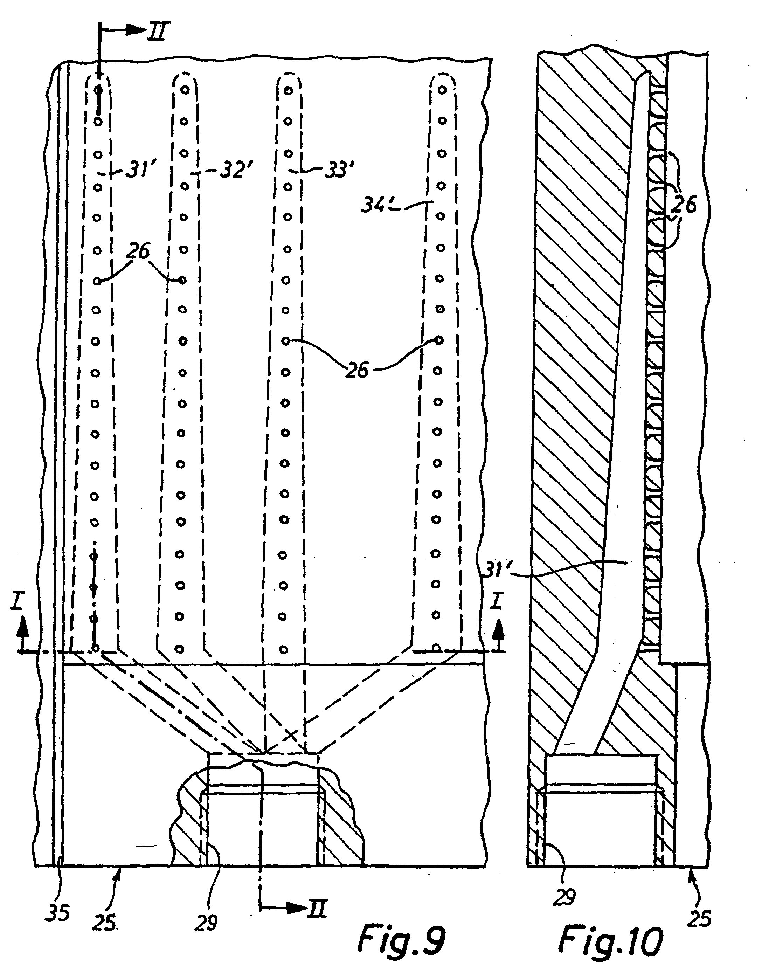

Ein Anschlußkanal 28 mit beispielsweise einem 3/4" Innengewinde 29 steht mit einer nicht dargestellten Flüssigkeit-Zuleitung in Verbindung. Der Anschlußkanal 28 ist bei dem dargestellten Ausführungsbeispiel in vier Abschnitte, 31, 32, 33, 34 aufgeteilt, die die im Behälterboden 25 integral ausgebildeten Flüssigkeitskanäle 30', 31', 32', 33' mit Behandlungsfluid versorgen, das aus den Einlaßöffnungen 26 ausströmt (vgl. insbesondere Fig. 9). Fig. 8 zeigt einen schematischen Querschnitt entlang der in Fig. 9 eingezeichneten Schnittlinie I-I. Die einzelnen Düsen 26 eines Flüssigkeitskanals sind äquidistant an der Behälterboden-Austrittsfläche 19 in Richtung quer zu den Substratflächen angeordnet, wobei die Flüssigkeitskanäle 31', 32', 33', 34' sich zu den Flüssigkeitskanalenden hin verjüngen, wie dies insbesondere auch aus Fig. 10 zu ersehen ist. Fig. 10 zeigt einen schematischen Querschnitt entlang der in Fig. 9 gezeichneten Schnittlinie II-II. Insbesondere aus Fig. 10 ist ersichtlich, daß die einzelnen Kanalarme 31', 32', 32', 34' zu den Kanalenden hin abnehmende Querschnittsflächen aufweisen. Dies ist in Fig. 8 ebenfalls durch entsprechende Querschnittsflächen der Flüssigkeitskanäle in den einzelnen Flüssigkeitskanälen angedeutet.

Wie aus Fig. 8 ersichtlich ist, liegt der Behälterboden 25 als einstückiges, fertiges Element vor und wird an einem Trägerteil 35 befestigt, in dem ein Schacht 36 für den Substrathalter 3 ausgebildet ist. Auf der anderen Seite des Substrathalters 3 ist in Fig. 8 der Behälterboden 25 entsprechend ausgebildet, ohne daß dies in Fig. 8 dargestellt ist.

Bei dem in Fig. 8 dargestellten Ausführungsbeispiel sind für den Substrathalter-Schacht 36 Einlaßöffnungen 37 vorgesehen, über die das Behandlungsflüssigkeit auch in den Substrathalter-Schacht 36 zur Spülung desselben und zur Strömungsbildung um den Substrathalter 3 herum eingeleitet wird. Bei dem dargestellten Ausführungsbeispiel werden die Einlaßöffnungen 37 für den Substrathalter-Schacht 36 von einem in dem Behälterbodenelement 25 ausgebildeten Flüssigkeitskanal 27 gespeist. Die Verbindungsstelle zwischen dem Behälterboden 25 und dem Trägerteil 35 ist dabei nicht fluiddicht. Daher ist es erforderlich, zwischen dem Behälterbodenelement 25 und dem Trägerteil 34 eine Dichtung 38 vorzusehen.

Die Ausbildung des Behälterbodens 25 in der dargestellten und beschriebenen Weise ist selbstverständlich auch für Behälter möglich, die eine andere Form als die in Fig. 8 dargestellte Behälterbodenform aufweisen. Auch ist es dem Fachmann möglich, die Anordnung und Ausgestaltung der Flüssigkeitskanäle und Kanalarme sowie der Auslaßöffnungen oder Düsen je nach den Gegebenheiten und Erfordernissen zu ändern und auszugestalten.

## Patentansprüche

1. Vorrichtung zum Behandeln von Substraten (2) mit einem eine Behandlungsflüssigkeit enthaltenden Behälter (12), und einem einstückigen Behälterboden (25), der Einlassöffnungen (26) für die Behandlungsflüssigkeit aufweist und den unteren Abschluss des die Behandlungsflüssigkeit aufnehmenden Behälters (12) bildet, **dadurch gekennzeichnet, dass** die Einlassöffnungen (26) für die Behandlungsflüssigkeit sowie Flüssigkeitskanäle (30', 31', 32', 33', 34') zur Versorgung der Einlassöffnungen (26) mit Behandlungsflüssigkeit integral innerhalb des Behälterbodens ausgebildet sind.

2. Vorrichtung nach Anspruch 1, **dadurch gekennzeichnet, dass** der Behälterboden (25) wenigstens einen Anschlusskanal (28) zur Einleitung der Behandlungsflüssigkeit in den Behälterboden (25) aufweist.

3. Vorrichtung nach einem der Ansprüche 1 oder 2, **dadurch gekennzeichnet, dass** der Anschlusskanal (28) in mehrere Abschnitte (31, 32, 33, 34) aufgeteilt ist.

4. Vorrichtung nach Anspruch 3, **dadurch gekennzeichnet, dass** vom Anschlusskanal (28) mehrere Flüssigkeitskanäle (31', 32', 33', 34') abzweigen.

5. Vorrichtung nach Anspruch 3 oder 4, **dadurch gekennzeichnet, dass** die Flüssigkeitskanäle (31', 32', 33', 34') in Strömungsrichtung zu den Kanalenden hin abnehmende Querschnittsflächen aufweisen.

6. Vorrichtung nach einem der Ansprüche 1 bis 5, **dadurch gekennzeichnet, dass** die Flüssigkeitskanäle (31' bis 34') Ausströmöffnungen aufweisen.

7. Vorrichtung nach einem der vorhergehenden Ansprüche, **gekennzeichnet durch** an den Seitenwänden (4, 5) des Behälters (12) vorgesehenen Entgasungsrinnen (14) zum Abführen von in der Behandlungsflüssigkeit enthaltenen oder bei der Einleitung der Behandlungsflüssigkeit gebildeten Blasen.

8. Vorrichtung nach Anspruch 7, **dadurch gekennzeichnet, dass** die Entgasungsrinnen (14) bei einer dem Behälterinneren zugewandte, im Querschnitt kreisbogenförmigen Behälterbodenoberfläche in seinem obersten Bereich an den Seitenwänden (4, 5) des Behälters vorgesehen sind.

9. Vorrichtung nach einem der Ansprüche 1 bis 7, **dadurch gekennzeichnet, dass** die dem Behälterinneren zugewandte Behälterbodenoberfläche eine gerundete Form aufweist.

10. Vorrichtung nach einem der vorhergehenden Ansprüche, **dadurch gekennzeichnet, dass** die Vorrichtung einen Substrathalter (3) aufweist, und dass im Bereich des Substrathalters (3) Einlassöffnungen (26) im Behälterboden (25) angeordnet sind, die die Behandlungsflüssigkeit in dem Behälterbereich über dem Substrathalter (3) lenken.

11. Vorrichtung nach Anspruch 10, **gekennzeichnet durch** Führungselemente (24) zum Führen der Behandlungsflüssigkeit im oder um den Bereich des Substrathalters (3).

## Claims

1. Device for treating substrates (2), comprising a container (12) containing a treatment liquid, and container base (25) of integral construction which has inlet openings (26) for the treatment liquid and forms the lower closure of the container (12) receiving the treatment liquid, **characterised in that** the inlet openings (26) for the treatment liquid as well as liquid channels (30', 31', 32', 33', 34') for supply of the inlet openings (26) with treatment liquid are integrally formed within the container base.

2. Device according to claim 1, **characterised in that** the container base (25) has at least one connection channel (28) for introduction of the treatment liquid into the container base (25).

3. Device according to one of claims 1 and 2, **characterised in that** the connection channel (28) is divided into several sections (31, 32, 33, 34).

4. Device according to claim 3, **characterised in that** several liquid channels (31', 32', 33', 34') branch off from the connection channel (28).

5. Device according to claim 3 or 4, **characterised in that** the liquid channels (31', 32', 33', 34') have cross-sectional areas reducing in flow direction towards the channels ends.

6. Device according to one of claims 1 to 5, **characterised in that** the liquid channels (31' to 34') have flow outlet openings.

7. Device according to one of the preceding claims, **characterised by** degasification grooves (14), which are provided at the side walls (4, 5) of the container (12), for conducting away bubbles contained in the treatment liquid or formed during introduction of the treatment liquid.

8. Device according to claim 7, **characterised in that** in the case of a container base surface which faces the container interior and is of circularly arcuate cross-section the degasification grooves (14) are provided in its uppermost region at the side walls (4, 5) of the container.

9. Device according to one of claims 1 to 7, **characterised in that** the container base surface facing the container interior has a rounded shape.

10. Device according to one of the preceding claims, **characterised in that** the device comprises a substrate holder (3) and that arranged in the container base (25) and in the region of the substrate holder (3) are inlet openings (26) which guide the treatment liquid in the container region over the substrate holder (3).

11. Device according to claim 10, **characterised by** guide elements (24) for guiding the treatment liquid in or around the region of the substrate holder (3).

## Revendications

1. Dispositif de traitement de substrats (2) avec un récipient (12) contenant un liquide de traitement, et un fond de récipient en une pièce (25) qui présente des ouvertures d'admission (26) pour le liquide de traitement et qui forme la fermeture inférieure du récipient (12) recevant le liquide de traitement, **caractérisé en ce que** les ouvertures d'admission (26) pour le liquide de traitement ainsi que des canaux de liquide (30', 31', 32', 33', 34') pour l'alimentation des ouvertures d'admission (26) en liquide de traitement sont réalisées intégralement à l'intérieur du fond de récipient.

2. Dispositif selon la revendication 1, **caractérisé en ce que** le fond de récipient (25) présente au moins un canal de raccordement (28) pour l'introduction du liquide de traitement dans le fond de récipient (25).

3. Dispositif selon l'une des revendications 1 ou 2, **caractérisé en ce que** le canal de raccordement (28) est divisé en plusieurs tronçons (31, 32, 33, 34).

4. Dispositif selon la revendication 3, **caractérisé en ce que** plusieurs canaux de liquide (31', 32', 33', 34') partent du canal de raccordement (28).

5. Dispositif selon la revendication 3 ou 4, **caractérisé en ce que** les canaux de liquide (31', 32', 33', 34') présentent des faces en section transversale diminuant dans la direction d'écoulement vers les extrémités des canaux.

6. Dispositif selon l'une des revendications 1 à 5, **caractérisé en ce que** les canaux de liquide (31' à 34') présentent des ouvertures d'écoulement.

7. Dispositif selon l'une des revendications précédentes, **caractérisé par** des rainures de dégazage (14) prévues aux parois latérales (4, 5) du récipient (12) pour l'évacuation de bulles se trouvant dans le liquide de traitement ou formées lors de l'introduction du liquide de traitement.

8. Dispositif selon la revendication 7, **caractérisé en ce que** les rainures de dégazage (14), dans une surface de fond de récipient en section transversale circulaire, orientée vers l'intérieur du récipient, sont prévues dans sa zone supérieure aux parois latérales (4, 5) du récipient.

9. Dispositif selon l'une des revendications 1 à 7, **caractérisé en ce que** la surface de fond de récipient orientée vers l'intérieur du récipient présente une forme arrondie.

10. Dispositif selon l'une des revendications précédentes, **caractérisé en ce que** le dispositif présente un porte-substrats (3), et **en ce que** sont disposées au voisinage du porte-substrats (3) des ouvertures d'admission (26) dans le fond de récipient (25) qui guident le liquide de traitement dans la zone du récipient sur le porte-substrats (3).

11. Dispositif selon la revendication 10, **caractérisé par** des éléments de guidage (24) pour guider le liquide de traitement dans ou autour de la zone du porte-substrats (3).
